# EUROPEAN PATENT APPLICATION

(11) **EP 4 484 511 A1**
(43) Date of publication of application: **01.01.2025**
(21) Application number: 23818707.4
(22) Date of filing: 16.01.2023
(51) Int. Cl.: C09J 7/10, C09J 7/30, C09J 123/08, C09J 11/06, C09J 11/04, H01L 31/048, H01L 31/055, C03C 27/12

(54) **ENCAPSULATION ADHESIVE FILM AND APPLICATION THEREOF**

(30) Priority: 06.06.2022 CN 202210627915
(71) Applicant: Hangzhou First Applied Material Co., Ltd., Hangzhou, Zhejiang 311300 (CN)
(72) Inventor: WANG, Long, Hangzhou, Zhejiang 311300 (CN); WEI, Mengjuan, Hangzhou, Zhejiang 311300 (CN); SANG, Yan, Hangzhou, Zhejiang 311300 (CN); HOU, Hongbing, Hangzhou, Zhejiang 311300 (CN); ZHOU, Guangda, Hangzhou, Zhejiang 311300 (CN)
(74) Representative: Berggren Oy
(86) International application number: PCT/CN2023/072426
(87) International publication number: WO 2023/236539

(57) **Abstract**

The present disclosure provides an encapsulation adhesive film, the encapsulation adhesive film comprises at least two layers, and the encapsulation adhesive film comprises an ultraviolet light absorption layer and an ultraviolet light conversion layer; the ultraviolet light absorption layer comprises a matrix resin and an ultraviolet light absorption agent; the ultraviolet light conversion layer comprises the matrix resin and an ultraviolet light conversion agent; the content of the ultraviolet light absorption agent in the ultraviolet light absorption layer is 0.1 g/m²-10 g/m²; the content of the ultraviolet light conversion agent in the ultraviolet light conversion layer is 0.1 g/m²-10 g/m². The ultraviolet light absorption agent in the ultraviolet light absorption layer can absorb the ultraviolet light of wavebands 200-400 nm, and the ultraviolet light conversion agent in the ultraviolet light conversion layer can convert the ultraviolet light of wavebands 280-380 nm into the visible light. The encapsulation adhesive film of the present disclosure comprises a multi-layers composite structure, the ultraviolet light absorption agent and the ultraviolet light conversion agent are dispersed in the different layers, and the ultraviolet light absorption agent and the ultraviolet light conversion agent do not interfere with each other, but effecting together to achieve simultaneously great ultraviolet light cutoff effect and high visible light transmittance, even to match different ultraviolet light absorption agent and ultraviolet light conversion agent reasonably according to the corresponding wavebands to achieve the desired effects.

## Description

This application claims the priority for Chinese Patent Application 202210627915.X, with a filing date of June 06, 2022. The aforementioned Chinese Patent Application is incorporated into this application in its entirety.

### Technical Field

The present disclosure relates to the field of photovoltaics, and in particular to encapsulation adhesive film and application thereof.

### Background

Ultraviolet light is a kind of electromagnetic wave with the wavelength of 400 nm-10 nm. And the proportion of the ultraviolet light in sunlight is less than 10%, but the ultraviolet light has a short wavelength and high energy which can cause great harm to the human body by prolonged exposure. The ultraviolet light can also cause great harm, such like reducing performance and shortening service life to many types of materials, especially organic materials. If the ultraviolet light cutoff effect of the encapsulation adhesive film is poor and the ultraviolet light transmittance is high, leading to poor reliability of the photovoltaic modules, such as yellowing, embrittling and cracking of the photovoltaic backsheet. However, the excessive addition of ultraviolet light absorption agent will affect the transmittance of visible light wavebands of the photovoltaic modules, affect the photoelectric conversion efficiency of the modules, yellow the encapsulation adhesive film and so on.

Photovoltaics, as the main force of clean energy, have been increasingly valued in recent years. With the development of the photovoltaic industry, all kind of technologies have made breakthroughs continuously, the photoelectric conversion efficiency has become higher and higher, and the cost of per kilowatt-hour has decreased constantly, the prospect of a bright future. The photoelectric conversion efficiency of the current monocrystalline PERC cells is close to the theoretical value of 24%, and the future improvement space is limited. The photoelectric conversion efficiency of the heterojunction (HJT) cells has exceeded 26%, coupled with the low light-induced degradation and the low temperature coefficient, the HJT cells are considered to be a new direction for the development of battery sheets. However, the HJT cells are sensitive to the ultraviolet light and have large power degradation after the aging of the ultraviolet light, which requires a better ultraviolet light cutoff capability of the encapsulation adhesive film. In addition, the laminated glass in automotive and architectural fields also requires the inter-film with a great ultraviolet light cutoff capability. And the existing technical solutions are mainly to add the ultraviolet light absorption agent to cutoff the ultraviolet light transmit the adhesive film. For the products with high ultraviolet light cutoff requirements, it is not possible to achieve the requirements or it is necessary to add a high proportion of the ultraviolet light absorption agent, which affects the other properties of the encapsulation adhesive film.

A Chinese invention CN114058271A discloses an adhesive film with different absorption wavebands of the ultraviolet light and a method of preparation thereof, and the composition of the invention contains both an ultraviolet light absorption agent and an ultraviolet light conversion agent, which can block the ultraviolet light wavebands selectively, blocking the ultraviolet light wavebands that are damaging to the photovoltaic cells, ensuring the undamaged light wavebands to transmit, and improving the power of the solar cells modules. However, mixing both the ultraviolet light absorption agent with the ultraviolet light conversion agent together and dispersing in the same layer, the ultraviolet light absorption agent and the ultraviolet light conversion agent may interfere and react with each other, so that affecting the products performance and reliability.

Therefore, there is a need for an encapsulation adhesive film that achieves simultaneously great ultraviolet light cutoff capability, high visible light transmittance, and great reliability.

### Summary

According to a first aspect of the present disclosure, the present disclosure provides an encapsulation adhesive film, the encapsulation adhesive film includes an ultraviolet light absorption layer and an ultraviolet light conversion layer; the ultraviolet light absorption layer includes a matrix resin and an ultraviolet light absorption agent; the ultraviolet light conversion layer includes the matrix resin and an ultraviolet light conversion agent; the content of the ultraviolet light absorption agent in the ultraviolet light absorption layer is 0.1 g/m²-10 g/m²; the content of the ultraviolet light conversion agent in the ultraviolet light conversion layer is 0.1 g/m²-10 g/m².

Further, the content of the ultraviolet light absorption agent in the ultraviolet light absorption layer is 5 g/m²-10 g/m²; the content of the ultraviolet light conversion agent in the ultraviolet light conversion layer is 0.1 g/m²-2 g/m².

Further, the content of the ultraviolet light conversion agent in the ultraviolet light conversion layer is 5 g/m²-10 g/m²; the content of the ultraviolet light absorption agent in the ultraviolet light absorption layer is 0.1 g/m²-2 g/m².

Further, the ultraviolet light absorption agent includes at least one of ethyl 2-cyano-3,3-diphenylpropenoate, p-methoxycinnamic acid ethylhexyl, isooctyl p-methoxycinnamate, dimethyl 4-methoxybenzylidene malonate, N-(2-ethoxyphenyl)-N'-(4-ethylphenyl)-oxalamide, 2-(2'-hydroxy-5'-tert-octylphenyl) benzotriazole, 2-(2'-hydroxy-3'-tert-butyl-5'-methylphenyl)-5-chlorobenzotriazole, 2-(4,6-, 3,5-di-tert-butyl-4-hydroxybenzoic acid) n-hexadecyl ester, 2-(4,6-diphenyl-1,3,5-triazine-2)-5-n-hexyloxyphenol, 2-(2'-hydroxy-5'-methylphenyl) benzotriazole and polysiloxane.

Further, the ultraviolet light conversion agent is selected from organic fluorescent pigments, Eu³⁺ doped rare earth oxides and quantum dots; the organic fluorescent pigments are selected from mixed rare earth coordination compounds of β-diketones and pyridine derivatives; the Eu³⁺ doped rare earth oxides are selected from one or more of Y₂Mo₆-Eu³⁺, Y₂O₂S-Eu³⁺, Gd₂O₃-Eu³⁺/Bi³⁺ and YVO₄-Eu³⁺; and the quantum dots are selected from one or more of Si quantum dots, GaAs quantum dots, CdS quantum dots, CdSe quantum dots, CdTe quantum dots, ZnS quantum dots, ZnSe quantum dots and ZnTe quantum dots.

Further, according to the light transmittance test standard of GB/T 2410-2008, the light transmittance of the encapsulation adhesive film in the ultraviolet light wavebands of wavelength 280-380 nm is not more than 20%; the light transmittance of the encapsulation adhesive film in the visible light wavebands of wavelength 400-1100 nm is not less than 85%.

According to another aspect of the present disclosure, the present disclosure also provides an electronic device, the electronic device includes an encapsulation adhesive film, the encapsulation adhesive film being the encapsulation adhesive film described in the first aspect; the electronic device is selected from any one of photovoltaic modules, an electroluminescent device, and a plasma display device; and further, the photovoltaic modules being HJT cells modules.

Further, the photovoltaic modules includes a glass layer, a first encapsulation adhesive film layer, a cell array, a second encapsulation adhesive film layer and a cover plate, the first encapsulation adhesive film layer being the encapsulation adhesive film described in the first aspect; the ultraviolet light absorption layer is provided on the cell array side of the photovoltaic modules, and the ultraviolet light conversion layer is provided on the glass layer side of the photovoltaic modules; the content of the ultraviolet light conversion agent in the ultraviolet light conversion layer is 5 g/m²-10 g/m²; the content of the ultraviolet light absorption agent in the ultraviolet light absorption layer is 0.1 g/m²-2 g/m².

Further, the photovoltaic modules includes the glass layer, the first encapsulation adhesive film layer, the cell array, the second encapsulation adhesive film layer and the cover plate, the second encapsulation adhesive film layer being the encapsulation adhesive film described in the first aspect; the ultraviolet light conversion layer is provided on the cell array side of the photovoltaic modules, and the ultraviolet light absorption layer is provided on the cover plate side of the photovoltaic modules; the content of the ultraviolet light absorption agent in the ultraviolet light absorption layer is 5 g/m²-10 g/m²; the content of the ultraviolet light conversion agent in the ultraviolet light conversion layer is 0.1 g/m²-2 g/m².

According to a third aspect of the present disclosure, the present disclosure also provides a laminated glass, the laminated glass includes at least two glass layers and an encapsulation adhesive film provided between adjacent the two glass layers, the encapsulation adhesive film being the encapsulation adhesive film described in the first aspect.

Applying the technical solutions of the present disclosure, the present disclosure has at least the following beneficial effects relative to the prior arts:
(1) The ultraviolet light absorption agent in the ultraviolet light absorption layer can absorb the ultraviolet light of wavebands 200-400 nm, and the ultraviolet light conversion agent in the ultraviolet light conversion layer ensures that the encapsulation adhesive film with high transmittance will convert the ultraviolet light that cannot be absorbed by the photovoltaic modules directly into the visible light that can be utilized by the photovoltaic modules, which can convert the ultraviolet light of wavebands 280-380 nm into the visible light, and it has the advantages such like high conversion efficiency of the ultraviolet light to the visible light, stable physicochemical properties and not easy to lose efficacy under the lighting. It is possible to match different ultraviolet light absorption agent and ultraviolet light conversion agent reasonably according to the corresponding wavebands to achieve the desired effects.

Dispersing the ultraviolet light absorption agent and the ultraviolet light conversion agent in the different layers, and the ultraviolet light absorption agent and the ultraviolet light conversion agent do not interfere with each other, but effecting together to achieve simultaneously great ultraviolet light cutoff effect and high visible light transmittance, to improve the photoelectric conversion efficiency of the solar cell sheets, to delay the self-aging process of the encapsulation adhesive film and to reduce the consumption of the ultraviolet light absorption agent, so as to have a high economic value and a great commercial application prospect.

### Brief Description of the Drawings

The drawings is a part of this present disclosure, used to provide a further understanding for the present disclosure, and the embodiments and their illustrations are used to explain the present disclosure instead of constituting an improper limitation for the present disclosure.
FIG. 1 illustrates a sectional view of the encapsulation adhesive film according to an embodiment of the present disclosure;
FIG. 2 illustrates a sectional view of the encapsulation adhesive film according to another embodiment of the present disclosure;
FIG. 3 illustrates a sectional view of the photovoltaic modules according to another embodiment of the present disclosure;
FIG. 4 illustrates a sectional view of the laminated glass according to another embodiment of the present disclosure.

Wherein, the above-mentioned drawings include the following drawing references:
01: Glass layer; 02: First encapsulation adhesive film layer; 03: Cell; 04: Second encapsulation adhesive film layer; 05: Cover plate; 06: First glass layer; 07: Encapsulation adhesive film layer; 08: Second glass layer; 11: Ultraviolet light conversion layer; 12: Ultraviolet light absorption layer; 13: Adhesive layer.

### Detailed Description of the Embodiments

It is noted that the embodiments and the features in the embodiments of the present disclosure may be combined with each other without conflict. The present disclosure will be further described in detail below with reference to the drawings and the embodiments.

In order to enable those skilled in the art to better understand the embodiments of the present disclosure, the technical solutions in the embodiments of the present disclosure will be described clearly and completely below with reference to the drawings in the embodiments of the present disclosure, and it is obvious that the described embodiments are only a part of all the embodiments of the present disclosure and not all of the embodiments. According to the embodiments in the present disclosure, all the other embodiments obtained by those ordinary skilled in the art without making any creative labor should be covered within the protection scope of the present disclosure.

Unless otherwise defined, the technical or scientific terms used in the present disclosure should have the ordinary meaning understood by those ordinary skilled in the art.

The present disclosure provides an encapsulation adhesive film, the encapsulation adhesive film includes an ultraviolet light absorption layer and an ultraviolet light conversion layer; the ultraviolet light absorption layer includes a matrix resin and an ultraviolet light absorption agent; the ultraviolet light conversion layer includes the matrix resin and an ultraviolet light conversion agent. The ultraviolet light absorption agent and the ultraviolet light conversion agent are dispersed in the different layers, and the ultraviolet light absorption agent and the ultraviolet light conversion agent cannot interfere with each other, but effecting together to achieve simultaneously great ultraviolet light cutoff effect and high visible light transmittance, even to match different ultraviolet light absorption agent and ultraviolet light conversion agent reasonably according to the corresponding wavebands to achieve the desired effect.

In an exemplary embodiment of the present disclosure, the content of the ultraviolet light absorption agent in the ultraviolet light absorption layer is 0.1 g/m³-10 g/m³, and for example the content of the ultraviolet light agent in the ultraviolet light absorption layer is 0.1 g/m³, 0.5 g/m³, 1 g/m³, 1.5 g/m³, 2 g/m³, 2.5 g/m³, 3 g/m³, 3.5 g/m³, 4 g/m³, 4.5 g/m³, 5 g/m³, 5.5 g/m³, 6 g/m³, 6.5 g/m³, 7 g/m³, 7.5 g/m³, 8 g/m³, 8.5 g/m³, 9 g/m³, 9.5 g/m³ or 10 g/m³. However, it is not limited to the specific values or ranges of values listed above, and other values or ranges of values above that are not listed apply equally. When the content of the ultraviolet light absorption agent is lower than 0.1 g/m², the blocking effect of the ultraviolet light is not enough, and the transmittance of the ultraviolet light is high; when the content of the ultraviolet light absorption agent is higher than 10 g/m², the high content ultraviolet light absorption agent will affect the transmittance of the visible light of the encapsulation adhesive film and yellow the encapsulation adhesive film easily. The content of the ultraviolet light conversion agent in the ultraviolet light conversion layer is 0.1 g/m²-10 g/m², and for example the content of the ultraviolet light conversion agent in the ultraviolet light conversion layer is 0.1 g/m², 0.5 g/m², 1 g/m², 1.5 g/m², 2 g/m², 2.5 g/m², 3 g/m², 3.5 g/m², 4 g/m², 4.5 g/m², 5 g/m², 5.5 g/m², 6 g/m², 6.5 g/m², 7 g/m², 7.5 g/m², 8 g/m², 8.5 g/m², 9 g/m², 9.5 g/m³ or 10 g/m². However, it is not limited to the specific values or ranges of values listed above, and other values or ranges of values above that are not listed apply equally. When the content of the ultraviolet light conversion agent is lower than 0.1 g/m³, the conversion efficiency of the ultraviolet light of the encapsulation adhesive film is poor, on the one hand, the gain of the transmittance of the visible light is poor, on the other hand, most of the ultraviolet light penetrate the encapsulation adhesive film, so as the blocking effect of the ultraviolet light is poor. When the content of the ultraviolet light conversion agent is higher than 10 g/m³, and the excessive content of the ultraviolet light conversion agent will cause the transmittance decrease and haze increase of the encapsulation adhesive film.

In an exemplary embodiment of the present disclosure, the content of the ultraviolet light conversion agent in the ultraviolet light conversion layer is 5 g/m²-10 g/m²; the content of the ultraviolet light absorption agent in the ultraviolet light absorption layer is 0.1 g/m²-2 g/m². When the encapsulation adhesive film is used in the front adhesive film layer of the photovoltaic modules, the ultraviolet light firstly passes through the ultraviolet light conversion layer and then passes through the ultraviolet light absorption layer, and if there is an excessive content of the ultraviolet light absorption agent, on the one hand it increases the production costs of the encapsulation adhesive film, on the other hand the excessive content of the ultraviolet light adsorption agent will cause the yellowing of the appearance and reduce the light transmittance of the encapsulation adhesive film.

In an exemplary embodiment of the present disclosure, the content of the ultraviolet light absorption agent in the ultraviolet light absorption layer is 5 g/m²-10 g/m²; the content of the ultraviolet light conversion agent in the ultraviolet light conversion layer is 0.1 g/m²-2 g/m². When the encapsulation adhesive film is used in the rear adhesive film layer of the photovoltaic modules, the light firstly passes through the ultraviolet light absorption layer to absorb most of the ultraviolet light, and then the unabsorbed part of the ultraviolet light is converted into the visible light through the ultraviolet light conversion layer, at this time, if there is an excessive content of the ultraviolet light conversion agent, on the one hand it increases the production costs of the encapsulation adhesive film, on the other hand the excessive content of the ultraviolet light conversion agent will cause the transmittance decrease and haze increase of the encapsulation adhesive film.

In an exemplary embodiment of the present disclosure, the thickness ratio of the ultraviolet light absorption layer and the ultraviolet light conversion layer is 1:10-10:1. A reasonable thickness distribution ensures that the ultraviolet light absorption layer and the ultraviolet light conversion layer exert a good synergistic effect to achieve simultaneously great ultraviolet light cutoff effect and high light transmittance. On the contrary, if the thickness difference between the ultraviolet absorption layer and the ultraviolet light conversion layer is too large, they cannot satisfy all the requirements well, and affect the reliability of the product ultimately. On the other hand, if the thickness difference between the ultraviolet light absorption layer and the ultraviolet light conversion layer is too large, it also increases the difficulty of production control.

In an exemplary embodiment of the present disclosure, the ultraviolet light absorption agent includes at least one of ethyl 2-cyano-3,3-diphenylpropenoate, p-methoxycinnamic acid ethylhexyl, isooctyl p-methoxycinnamate, dimethyl 4-methoxybenzylidene malonate, N-(2-ethoxyphenyl)-N'-(4-ethylphenyl)-oxalamide, 2-(2'-hydroxy-5'-tert-octylphenyl) benzotriazole, 2-(2'-hydroxy-3'-tert-butyl-5'-methylphenyl)-5-chlorobenzotriazole, 2-(4,6-, 3,5-di-tert-butyl-4-hydroxybenzoic acid) n-hexadecyl ester, 2-(4,6-diphenyl-1,3,5-triazine-2)-5-n-hexyloxyphenol, 2-(2'-hydroxy-5'-methylphenyl) benzotriazole and polysiloxane.

In an exemplary embodiment of the present disclosure, the ultraviolet light conversion agent has the function of converting the light with ultraviolet wavebands into the visible light with longer wavebands. Specifically, the ultraviolet light conversion agent absorbs ultraviolet light through its own chromophoric group, causing the energy level leap of π-electrons in the molecule, emitting a longer light wave to achieve the objective of light conversion. And at the same time, the internal molecules of the light-converting substance absorb ultraviolet light by means of relay transmission and so as excite and emit the light wavebands with longer wavelengths, improving the power generation efficiency of the solar cells effectively, increase revenue. The ultraviolet light conversion agent is selected from organic fluorescent pigments, Eu3+ doped rare earth oxides and quantum dots.

In an exemplary embodiment of the present disclosure, the Eu³⁺ doped rare earth oxides are selected from one or more of Y₂Mo₆-Eu³⁺, Y₂O₂S-Eu³⁺, Gd₂O₃-Eu³⁺/Bi³⁺ and YVO₄-Eu³⁺.

In an exemplary embodiment of the present disclosure, the average size of the quantum dots is less than 10 nm, and the standard deviation of the size is greater than 10% of the average size and less than 30% of the average size; And the quantum dots are surface modified by a surface modifier, and the surface modifier is chemically reacted or physically coupled with the quantum dots at one end, and is connected to the matrix resin at the other end. The quantum dots are selected from any one of elementary substance quantum dots of group IV-A elements, alloy quantum dots compounded from elementary substance of group IV-A elements, compound quantum dots compounded from any one of group III-A elements and any one of group V-A elements, and compound quantum dots compounded from any one of group II-B elements and any one of group VI-A elements. The quantum dots are selected from one or more of Si quantum dots, GaAs quantum dots, CdS quantum dots, CdSe quantum dots, CdTe quantum dots, ZnS quantum dots, ZnSe quantum dots and ZnTe quantum dots. The size of the semiconductor quantum dots should be in a quantum-limited state, i.e. less than 10 nm. According to the maximum utilization of the spectrum in the 300-500 nm, i.e. the widest absorption bands, and the standard deviation of the size distribution of the quantum dots is less than 30% of the average size and more than 10% of the average size. If the standard deviation is too small, that indicates the size of the quantum dots is too concentrated, resulting in a narrower absorption bands. If the standard deviation is too large, that indicates the size of the quantum dots is too dispersed, and resulting in a lower absorption coefficient at each particular wavebands. The emission spectrum of the semiconductor quantum dots in the wavebands of 500-1100 nm can be adjusted by the type and size of the quantum dots.

In an exemplary embodiment of the present disclosure, in order to enable the semiconductor quantum dots to have better compatibility with the matrix resin, and the semiconductor can be preformed with surface modification. The surface modifier has the group that can chemically reacted or physically coupled with the quantum dots at one end, such as CH₂=CH, SH, OH, NH₂, and the surface modifier also has the other group that is compatible with the matrix resin at the other end, depending on the type of the matrix resin. When the matrix resin is a polar ethylene vinyl acetate copolymer, the other group of the surface modifier can be COOH, COOCH₃, etc. And when the matrix resin is a nonpolar ethylene-α olefin copolymer, the other group of the surface modifier can be CH₃, Ph, etc.

In an exemplary embodiment of the present disclosure, the organic fluorescent pigments are selected from mixed rare earth coordination compounds of β-diketones and pyridine derivatives.

Further, the matrix resin is selected from one or more of ethylene vinyl acetate copolymer, ethylene-α olefin copolymer, ethylene methyl methacrylate copolymer, and polyvinyl butyral copolymer. And the matrix resin is preferably ethylene vinyl acetate copolymer, ethylene-α olefin copolymer, or the polymer blends therebetween, or the polymer blends of a plurality of different ethylene vinyl acetate copolymer or the polymer blends of a plurality of different ethylene-α olefin copolymer. In the ethylene vinyl acetate copolymer, the content of the vinyl acetate is 15-35wt%. And in the ethylene-α olefin copolymer, the α-olefin is one of the following: 1-pentene, 1-hexene, 4-methyl-1-hexene, 1-octene, 1-decene, 1-dodecene, 4-ethyl-1-hexene and 5-methyl-1-heptene. The molar content of the α-olefin in the ethylene-α olefin copolymer is 10%-50%. The matrix resin is required to satisfy the following conditions:
1. The initial melting temperature is less than 80 °C measured by the differential scanning calorimetry (DSC);
2. The MFR is 2.5-40 g/min, preferably 3-30 g/min measured by a melt index instrument.

In an exemplary embodiment of the present disclosure, the ultraviolet light absorption layer and the ultraviolet light conversion layer of the encapsulation adhesive film may also be added with a photoinitiator, a silane coupling agent, an assistant crosslinking agent, a light stabilizer and other additives.

In an exemplary embodiment of the present disclosure, the mass percentage of the photoinitiator is 0-3 wt%, and for example the mass percentage of the photoinitiator is 0, 1 wt%, 1.5 wt%, 2 wt%, 2.5 wt%, or 3 wt%, etc. The photoinitiator is selected from one or more of tert-butyl peroxide isopropyl carbonate, 2,5-dimethyl-2,5-di-(tert-butyl peroxide) hexane, tert-butylperoxy 2-ethylhexyl carbonate, 1,1 -bis(tert-butylperoxy)-3,3,5-trimethylcyclohexane, 1,1-bis(tert-pentylperoxy)-3,3,5-trimelcyclohexane, 1,1-bis(tert-pentylperoxy) cyclohexane, 1,1-bis(tert-butylperoxy) cyclohexane, 2,2-bis(tert-butylperoxy) butane, tert-amylperoxy 2-ethylhexyl carbonate, 2,5-dimethyl-2,5-dimethyl-2,5-dimethyl-2,5-bis(benzoyl peroxide)-hexane, tert-amyl peroxycarbonate, tert-butyl peroxy 3,3,5-trimethylhexanoate, azodiisobutyronitrile, azodiisovaleronitrile, azobisisoheptonitrile, dimethyl azobisisobutyrate, 2,2'-azobis(2-methylpropionamidine) dihydrochloride, 2,2'-azobis[2-(2-imidazolin-2-yl)propane] dihydrochloride and 1-[(cyano-1-methylethyl)azo] formamide.

In an exemplary embodiment of the present disclosure, the mass percentage of the silane coupling agent is 0.05-1 wt%, and for example the mass percentage of the silane coupling agent is 0.05 wt%, 0.06 wt%, 0.07 wt%, 0.08 wt%, 0.09 wt%, 0.1 wt%, 0.2 wt%, 0.3 wt%, 0.4 wt%, 0.5 wt%, 0.6 wt%, 0.7 wt%, 0.8 wt%, 0.9 wt% or 1 wt%, etc. The silane coupling agent is selected from one or more of vinyl triethoxysilane, vinyl trimethoxysilane, vinyl tri-tert-butylperoxysilane, vinyl triacetoxysilane, vinyl tris (β-methoxyethoxy) silane, γ-aminopropyl triethoxysilane, γ-methacryloyloxy propyltrimethoxysilane, γ-glycidyl ether propyltrimethylsilane and 3-am inopropyltrimethylsilane.

In an exemplary embodiment of present disclosure, the mass percentage of the assistant crosslinking agent is 0.2-2 wt%, and for example the mass percentage of the assistant crosslinking agent is 0.2 wt%, 0.3 wt%, 0.4 wt%, 0.5 wt%, 0.6 wt%, 0.7 wt%, 0.8 wt%, 0.9 wt%, 1 wt%, 1.1 wt%, 1.2 wt%, 1.3 wt%, 1.4 wt%, 1.5 wt%, 1.6 wt%, 1.7 wt%, 1.8 wt%, 1.9 wt% or 2 wt%, etc. The assistant crosslinking agent is selected from one or more of triallyl isocyanurate, triallyl cyanurate, trimethylolpropane triacrylate, trimethylolpropane trimethacrylate, pentaerythritol triacrylate, tris[2-(acryloyloxy)ethyl] isocyanurate, ethoxylated trimethylolpropane triacrylate, propolylated trimethylolpropane triacrylate, ethoxylated glycerol triacrylate, propoxylated glycerol triacrylate, pentaerythritol tetraacrylate, ethoxylated pentaerythritol tetraacrylate, trimethylolpropane tetraacrylate, bis(trimethylolpropane) tetraacrylate, bis(trimethylolpropane) tetramethylacrylate, pentaerythritol tetraacrylate propoxide, 2,4,6-tris-(2-propenyloxy)-1,3,5-trizaine, tricyclodecane dimethanol diacrylate, propoxy neopentyl glycol diacrylate, ethoxybisphenol A diacrylate, ethoxybisphenol A dimethacrylate, 2-butyl-2-ethyl-1,3-propanediol diacrylate, diethylene glycol dimethacrylate, triethylene glycol dimethacrylate and poly (ethyleneglycol) dimethacrylate.

In an exemplary embodiment of present disclosure, the mass percentage of the light stabilizer is 0.05-0.5 wt%, and for example the mass percentage of the light stabilizer is 0.05 wt%, 0.1 wt%, 0.2 wt%, 0.3 wt%, 0.4 wt% or 0.5 wt%, etc. The light stabilizer is used for encapsulation adhesive film conventionally, and may be one or more of the following in any ratio: bis(2,2,6,6-tetramethyl-4-piperidinyl) sebacate, 2,4-dichloro-6-(4-morpholino)-1,3,5-triazine, bis-1-decanoxy-2,2,6,6-tetramethylpiperidin-4-ol sebacate, butanedioic acid polymer with 4-hydroxy-2,2,6,6-tetramethyl-1-piperidneethanol, the polymer of N,N'-bis(2,2,6,6-tetramethylpiperidin-4-yl) hexane-1,6-diamine and 2,4-dichloro-6-(1,1,3,3-tetramethylbutyl) amino-1,3,5-triazine, the polymer of N,N'-bis (2,2,6,6-tetramethylpiperidin-4-yl) hexane-1,6-diamine and 2,4-dichloro-6-(4-morpholino)-1,3,5-triazine, the polymer of N,N'-bis (1,2,2,6,6-pentamethyl-4-piperidinyl)-1,6-hexanediamine and morpholine-2,4,6-trichloro-1,3,5-triazine, the composite of bis(1,2,2,6,6-pentamethyl-4-piperidinyl) sebacate and methyl-1,2,2,6,6-pentamethyl-4-piperidinyl sebacate, and the polymer of succinic acid and 4-hydroxy-2,2,6,6-tetramethyl-1-piperidinol. And the light stabilizer is preferably bis(2,2,6,6-tetramethyl-4-piperidinyl) sebacate or 2,4-dichloro-6-(4-morpholino)-1,3,5-triazine.

In an exemplary embodiment of present disclosure, the encapsulation adhesive film may also include an adhesive layer or a functional layer, and the functional layer may be an anti-corrosion layer, an anti-PID layer and a water proof layer, etc. The adhesive layer or the functional layer may be placed on either side of the ultraviolet light conversion layer and the ultraviolet light absorption layer or in the middle of the ultraviolet light conversion layer and the ultraviolet light absorption layer.

In an exemplary embodiment of present disclosure, according to the light transmittance test standard of GBIT 2410-2008, the light transmittance of the encapsulation adhesive film in the ultraviolet light wavebands of wavelength 280-380 nm is not more than 20%; the light transmittance of the encapsulation adhesive film in the visible light wavebands of wavelength 400-1100 nm is not less than 85%.

The preparation method of the encapsulation adhesive film in the present disclosure includes the following steps: mixing the raw materials of each layer according to the proportion, extruding the intermediate products separately from the respective extruders with the set temperature, distributing the intermediate products through the distributor, molding the intermediate products through the die, embossing the intermediate products through the roller, and then obtaining the encapsulation adhesive film.

The preparation method of the encapsulation adhesive film in the present disclosure further includes composite molding, specifically mixing the raw materials of each layer according to the proportion, extruding the intermediate materials into a single-layer film with the set thickness separately from the respective extruders, stacking the various layers of films at a time according to a set structure, laminating the intermediate products through the lamination roller, embossing the intermediate products through the roller, and then obtaining the encapsulation adhesive film.

According to another aspect of the present disclosure, the present disclosure further provides an electronic device, the electronic device includes an encapsulation adhesive film, the encapsulation adhesive film being the encapsulation adhesive film described in the first aspect; the electronic device is selected from any one of photovoltaic modules, an electroluminescent device, and a plasma display device.

In a preferred embodiment of the present disclosure, the photovoltaic modules being HJT cells modules. The HJT cells modules are sensitive to the ultraviolet light and have large power degradation after the aging of the ultraviolet light, which requires a better ultraviolet light cutoff capability of the encapsulation adhesive film. However, the encapsulation adhesive film of the present disclosure is used in the HJT cells modules, which can solve the affection of the ultraviolet light on the HJT cells and avoid the power degradation after the aging of the ultraviolet light.

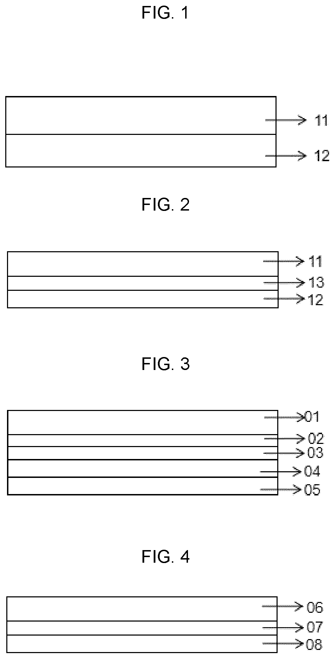

In a preferred embodiment of the present disclosure, as shown in FIG. 3, the photovoltaic modules includes the glass layer 01, the first encapsulation adhesive film layer 02, the cell array 03, the second encapsulation adhesive film layer 04 and the cover plate 05, the glass layer being in the incident direction of the sunlight, and the cover plate is made of glass or polymer materials. The first encapsulation adhesive film layer 02 being the encapsulation adhesive film described in the first aspect; the ultraviolet light absorption layer 12 is provided on the cell array side of the photovoltaic modules, and the ultraviolet light conversion layer 11 is provided on the glass layer side of the photovoltaic modules; the content of the ultraviolet light conversion agent in the ultraviolet light conversion layer is 5 g/m²-10 g/m²; the content of the ultraviolet light absorption agent in the ultraviolet light absorption layer is 0.1 g/m²-2 g/m². The sunlight firstly passes through the ultraviolet light conversion layer of the encapsulation adhesive film to convert the ultraviolet light into the visible light, and then the ultraviolet light adsorption layer is utilized to absorb the remaining ultraviolet light, so as to achieve simultaneously great ultraviolet light cutoff effect and high visible light transmittance.

In a preferred embodiment of the present disclosure, as shown in FIG. 3, the photovoltaic modules includes the glass layer 01, the first encapsulation adhesive film layer 02, the cell array 03, the second encapsulation adhesive film layer 04 and the cover plate 05, the glass layer being in the incident direction of the sunlight, and the cover plate is made of glass or polymer materials. The second encapsulation adhesive film layer being the encapsulation adhesive film described in the first aspect; the ultraviolet light conversion layer is provided on the cell array side of the photovoltaic modules, and the ultraviolet light absorption layer is provided on the cover plate side of the photovoltaic modules; the content of the ultraviolet light absorption agent in the ultraviolet light absorption layer is 5 g/m²-10 g/m²; the content of the ultraviolet light conversion agent in the ultraviolet light conversion layer is 0.1 g/m²-2 g/m². The sunlight firstly passes through the ultraviolet light absorption layer of the encapsulation adhesive film to absorb most of the ultraviolet light, and then the ultraviolet light conversion layer is utilized to convert the ultraviolet light into the visible light, so as to enhance the ultraviolet light cutoff capability of the encapsulation adhesive film greatly.

The present disclosure also provides a laminated glass as shown in FIG.4, the laminated glass includes at least two glass layers, a first glass layer 06 and a second glass layer 8, and an encapsulation adhesive film 07 provided between adjacent the two glass layers, the encapsulation adhesive film 07 being the encapsulation adhesive film described in the first aspect. In the automotive and architectural fields, most of the laminated glass has an insufficient ultraviolet light cutoff capability, causing harm to human physical health, and damaging the functional layer materials with special functions in the laminated glass, such as the PDLC film in privacy glass. The laminated glass in automotive and architectural fields also requires the inter-film with a great ultraviolet light cutoff capability. And the existing technical solutions are mainly to add the ultraviolet light absorption agent to cutoff the ultraviolet light transmit the adhesive film. For the products with high ultraviolet light cutoff requirements, it is not possible to achieve the requirements or it is necessary to add a high proportion of the ultraviolet light absorption agent, which affects the other properties of the encapsulation adhesive film.

The present disclosure is described in further detail below with the specific embodiments, which are not to be construed as limiting the protection scope claimed herein.

### Embodiment 1

Embodiment 1 provided an encapsulation adhesive film as shown in FIG. 1, the encapsulation adhesive film included two layers, an ultraviolet light absorption layer 12 and an ultraviolet light conversion layer 11; and the ultraviolet light absorption layer 12 included a matrix resin and an ultraviolet light absorption agent, specifically the matrix resin was EVA, and the ultraviolet light absorption agent was 2-(2'-hydroxy-3'-tert-butyl-5'-methylphenyl) -5-chlorobenzotriazole; and the content of the ultraviolet light absorption agent in the ultraviolet light absorption layer 12 was 5 g/m². The ultraviolet light conversion layer 11 included the matrix resin and an ultraviolet light conversion agent, specifically the matrix resin was EVA, and the ultraviolet light conversion agent was Y₂Mo₆-Eu³⁺; and the content of the ultraviolet light conversion agent in the ultraviolet light conversion layer 11 was 4 g/m².

### Embodiment 2

Embodiment 2 differed from Embodiment 1 in that the content of the ultraviolet light absorption agent in the ultraviolet light absorption layer was 5 g/m². And the content of the ultraviolet light absorption agent in the ultraviolet absorption layer was 0.1 g/m².

### Embodiment 3

Embodiment 3 differed from Embodiment 1 in that the content of the ultraviolet light absorption agent in the ultraviolet light absorption layer was 10 g/m². And the content of the ultraviolet light absorption agent in the ultraviolet absorption layer was 2 g/m².

### Embodiment 4

Embodiment 4 differed from Embodiment 1 in that the content of the ultraviolet light absorption agent in the ultraviolet light absorption layer was 10 g/m². And the content of the ultraviolet light absorption agent in the ultraviolet absorption layer was 0.1 g/m².

### Embodiment 5

Embodiment 5 differed from Embodiment 1 in that the content of the ultraviolet light absorption agent in the ultraviolet light absorption layer was 5 g/m². And the content of the ultraviolet light absorption agent in the ultraviolet absorption layer was 2 g/m².

### Embodiment 6

Embodiment 6 differed from Embodiment 1 in that the content of the ultraviolet light absorption agent in the ultraviolet light absorption layer was 6 g/m². And the content of the ultraviolet light absorption agent in the ultraviolet absorption layer was 1 g/m².

### Embodiment 7

Embodiment 7 differed from Embodiment 1 in that the content of the ultraviolet light absorption agent in the ultraviolet light absorption layer was 2 g/m². And the content of the ultraviolet light absorption agent in the ultraviolet absorption layer was 5 g/m².

### Embodiment 8

Embodiment 8 differed from Embodiment 1 in that the content of the ultraviolet light absorption agent in the ultraviolet light absorption layer was 0.1 g/m². And the content of the ultraviolet light absorption agent in the ultraviolet absorption layer was 5 g/m².

### Embodiment 9

Embodiment 9 differed from Embodiment 1 in that the content of the ultraviolet light absorption agent in the ultraviolet light absorption layer was 2 g/m². And the content of the ultraviolet light absorption agent in the ultraviolet absorption layer was 10 g/m².

### Embodiment 10

Embodiment 10 differed from Embodiment 1 in that the content of the ultraviolet light absorption agent in the ultraviolet light absorption layer was 0.1 g/m². And the content of the ultraviolet light absorption agent in the ultraviolet absorption layer was 10 g/m².

### Embodiment 11

Embodiment 11 differed from Embodiment 1 in that the content of the ultraviolet light absorption agent in the ultraviolet light absorption layer was 1 g/m². And the content of the ultraviolet light absorption agent in the ultraviolet absorption layer was 6 g/m².

### Embodiment 12

Embodiment 12 differed from Embodiment 1 in that the content of the ultraviolet light absorption agent in the ultraviolet light absorption layer was 0.1 g/m². And the content of the ultraviolet light absorption agent in the ultraviolet absorption layer was 0.1 g/m².

### Embodiment 13

Embodiment 13 differed from Embodiment 1 in that the content of the ultraviolet light absorption agent in the ultraviolet light absorption layer was 10 g/m². And the content of the ultraviolet light absorption agent in the ultraviolet absorption layer was 10 g/m².

### Embodiment 14

Embodiment 14 differed from Embodiment 1 in that the ultraviolet light absorption agent was p-methoxycinnamic acid ethylhexyl.

### Embodiment 15

Embodiment 15 differed from Embodiment 1 in that the ultraviolet light absorption agent was dimethyl 4-methoxybenzylidene malonate.

### Embodiment 16

Embodiment 16 differed from Embodiment 1 in that the ultraviolet light absorption agent was N-(2-ethoxyphenyl)-N'-(4-ethylphenyl)-ethlyene diamide.

### Embodiment 17

Embodiment 17 differed from Embodiment 1 in that the ultraviolet light absorption agent was ethyl 2-cyano-3, 3-diphenylpropenoate.

### Embodiment 18

Embodiment 18 differed from Embodiment 1 in that the ultraviolet light conversion agent was mixed rare earth coordination compounds of β-diketones and pyridine derivatives.

### Embodiment 19

Embodiment 19 differed from Embodiment 1 in that the ultraviolet light conversion agent was GaAs quantum dots.

### Embodiment 20

Embodiment 20 differed from Embodiment 1 in that the ultraviolet light absorption layer further included 0.5 parts of a crosslinking agent (dicumyl peroxide), 0.5 parts of an assistant crosslinking agent (triallyl isocyanurate), 0.1 parts of a heat stabilizer (pentaerythritol tetrakis [3-(3',5'-di-tert-butyl-4'-hydroxyphenyl) propionate]), 0.1 parts of a light stabilizer (poly-{6-[(1,1,3,3-tetramethylbutyl)amino-1,3,5-triazine-2,4-diyl][(2,2,6,6-tetramethyl-4-pi peridyl)imino]-1,6-hexanediyl[(2,2,6,6-tetramethyl-4-piperidyl)imino)}). And the ultraviolet light conversion layer further included 0.5 parts of a crosslinking agent (dicumyl peroxide), 0.5 parts of an assistant crosslinking agent (triallyl isocyanurate), 0.1 parts of a heat stabilizer (pentaerythritol tetrakis [3-(3',5'-di-tert-butyl-4'-hydroxyphenyl) propionate]), 0.1 parts of a light stabilizer (poly-{6-[(1,1,3,3-tetramethylbutyl)amino-1,3,5-triazine-2,4-diyl][(2,2,6,6-tetramethyl-4-pi peridyl)imino]-1,6-hexanediyl[(2,2,6,6-tetramethyl-4-piperidyl)imino)}).

### Embodiment 21

Embodiment 21 differed from Embodiment 1 in that the matrix resin was ethylene-1-octene copolymer.

### Embodiment 22

Embodiment 22 differed from Embodiment 1 in that the matrix resin was ethylene-methyl methacrylate copolymer.

### Embodiment 23

Embodiment 23 differed from Embodiment 1 in that the encapsulation adhesive film included three layers, sequentially ultraviolet light absorption layer, an ultraviolet light conversion layer and ultraviolet light absorption layer.

### Embodiment 24

Embodiment 24 differed from Embodiment 1 in that the encapsulation adhesive film included three layers, sequentially ultraviolet light conversion layer, an ultraviolet light absorption layer and ultraviolet light conversion layer.

### Embodiment 25

Embodiment 25 differed from Embodiment 1 in that, as shown in FIG. 2, the encapsulation adhesive film included three layers, sequentially an ultraviolet light absorption layer 12, an adhesive layer 13 and an ultraviolet light conversion layer 11, and the adhesive layer 13 did not contain any ultraviolet light additives.

### Comparative embodiment 1

Comparative embodiment 1 differed from Embodiment 1 in that the content of the ultraviolet light absorption agent in the ultraviolet light absorption layer was 0.01 g/m³.

### Comparative embodiment 2

Comparative embodiment 2 differed from Embodiment 1 in that the content of the ultraviolet light absorption agent in the ultraviolet light absorption layer was 12 g/m³.

### Comparative embodiment 3

Comparative embodiment 3 differed from Embodiment 1 in that the content of the ultraviolet light conversion agent in the ultraviolet light conversion layer was 0.01 g/m³.

### Comparative embodiment 4

Comparative embodiment 4 differs from Embodiment 1 in that the content of the ultraviolet light conversion agent in the ultraviolet light conversion layer was 12 g/m³.

### Comparative embodiment 5

Comparative embodiment 5 differed from Embodiment 1 in that the encapsulation adhesive film was a single-layer film, the encapsulation adhesive film included a matrix resin (EVA), an ultraviolet light absorption agent (ethyl 2-cyano-3,3-diphenylpropenoate), and an ultraviolet light conversion agent (Y₂Mo₆-Eu³⁺); the content of the ultraviolet light absorption agent was 5 g/m³, and the content of the ultraviolet light conversion agent was 4 g/m³.

### Performance testing

The encapsulation adhesive films were prepared by the above embodiments, and the performance of these encapsulation adhesive films was evaluated by the following testing methods.
1. The ultraviolet light aging performance: controlling the surface temperature of the test samples of 60 ± 5 °C, irradiating the test samples with UVA and UVB wavebands, and controlling the irradiation dose of 60 KWh/m².
   Characterization method: the yellowing index (ΔYI) referring to GB2409-80 *"The testing method of plastic yellowing index"* for analysis. In method 1, the light firstly passes through the ultraviolet light absorption layer and then to the ultraviolet light conversion layer; And in method 2, the light firstly passes through the ultraviolet light conversion layer and then to the ultraviolet light absorption layer.
2. The light transmittance and haze: the light transmittance and haze referring to GBIT 2410-2008, further the light transmittance and haze of the encapsulation adhesive film in the ultraviolet light wavelength of 280-380 nm and the visible light wavelength of 400-1100 nm are determined by the ultraviolet light-visible light spectrophotometer. In method 1, the light firstly passes through the ultraviolet light absorption layer and then to the ultraviolet light conversion layer; And in method 2, the light firstly passes through the ultraviolet light conversion layer and then to the ultraviolet light absorption layer.
3. The preparation of the photovoltaic modules:
   A series photovoltaic modules: the front adhesive film layers were used the encapsulation adhesive film of Embodiments 7-11, Embodiment 12-22, Embodiment 24-25 and Comparative embodiment 1-5, and the ultraviolet light absorption layer of the encapsulation adhesive film of Embodiment 7-11, Embodiments 12-22 and Comparative embodiment 1-5 were provided on the cell array side of the photovoltaic modules, and the ultraviolet light conversion layer of the encapsulation adhesive film were provided on the glass layer side of the photovoltaic modules, and the cells were all used A manufacturer's HJT cells, and the rear adhesive films layer were all used F806PS adhesive film.

B series photovoltaic modules: the rear adhesive film layers were used the encapsulation adhesive film of Embodiment 1-6, Embodiment 12-23, Embodiment 25 and Comparative embodiment 1-5, and the ultraviolet light conversion layer of the encapsulation adhesive film of Embodiment 1-6, Embodiment 12-22 and Comparative embodiment 1-5 were provided on the cell array side of the photovoltaic modules, and the ultraviolet light absorption layer of the encapsulation adhesive film were provided on the cover plate side of the photovoltaic modules, and the cells were all used A manufacturer's HJT cells, and the front adhesive films layer were all used F406PS adhesive film.

The photovoltaic modules completed aging tests with reference to the IEC61730 standard sequence, and the power degradation were calculated before and after the aging.

**Table 1**

| Numb er | Method 1 | | | Method 2 | | | Yellowing index in UVA | | Yellowing index in UVB | |
|---|---|---|---|---|---|---|---|---|---|---|
| | Light transmittance | | Haze | Light transmittance | | Haze | | | | |
| | 280-3 | 400-1 | 400-7 | 280-3 | 400-1 | 400- | Met | Met | Met | Met |
| | 80nm | 100n m | 00 nm | 80nm | 100n m | 700n m | hod 1 | hod 2 | hod 1 | hod 2 |
| Embo diment 1 | 9.1 | 89.8 | 3.51 | 9.3 | 90.5 | 3.56 | 1.02 | 3.15 | 1.33 | 3.98 |
| Embo diment 2 | 14.2 | 89.6 | 0.72 | 14.4 | 90.3 | 0.72 | 1.03 | 1.56 | 1.35 | 1.76 |
| Embo diment 3 | 6.1 | 86.1 | 1.89 | 6.3 | 86.4 | 1.89 | 0.98 | 2.25 | 1.18 | 2.56 |
| Embo diment 4 | 6.5 | 86.3 | 0.73 | 6.6 | 86.7 | 0.74 | 0.94 | 1.58 | 1.08 | 1.78 |
| Embo diment 5 | 9.3 | 88.9 | 1.86 | 9.5 | 89.9 | 1.86 | 1.06 | 2.24 | 1.37 | 2.59 |
| Embo diment 6 | 8.5 | 88 | 1.12 | 8.7 | 88.8 | 1.12 | 0.99 | 1.89 | 1.15 | 2.05 |
| Embo diment 7 | 13.2 | 90.1 | 5.38 | 13.3 | 90.8 | 5.38 | 2.32 | 3.56 | 2.62 | 4.35 |
| Embo diment 8 | 18.8 | 90.6 | 5.41 | 19.0 | 91.3 | 5.42 | 3.52 | 3.63 | 3.82 | 4.29 |
| Embo diment 9 | 12.3 | 88.9 | 18.9 | 12.4 | 89.5 | 19.2 | 2.48 | 4.36 | 2.78 | 4.96 |
| Embo diment 10 | 16.8 | 89.7 | 19 | 17.1 | 90.4 | 19.3 | 4.75 | 4.89 | 5.05 | 4.93 |
| Embo diment 11 | 14.3 | 89.1 | 8.32 | 14.5 | 90.6 | 8.38 | 2.88 | 3.88 | 3.18 | 4.75 |
| Embo diment 12 | 19.8 | 91.9 | 0.7 | 20.0 | 92.5 | 0.71 | 1.15 | 1.46 | 1.45 | 1.71 |
| Embo diment 13 | 2.91 | 85.1 | 19.2 | 4.92 | 85.3 | 19.3 | 1.09 | 4.93 | 1.12 | 4.99 |
| Embo diment 14 | 9.3 | 89.8 | 3.55 | 9.4 | 90.4 | 3.56 | 1.05 | 3.25 | 1.32 | 4.05 |
| Embo diment 15 | 9.2 | 89.6 | 3.51 | 9.3 | 90.5 | 3.56 | 1.04 | 3.1 | 1.3 | 3.98 |
| Embo diment 16 | 9.1 | 89.7 | 3.53 | 9.3 | 90.2 | 3.56 | 1.05 | 3.11 | 1.28 | 3.92 |
| Embo diment 17 | 9 | 89.8 | 3.56 | 9.2 | 90.3 | 3.56 | 1.06 | 3.31 | 1.33 | 2.99 |
| Embo diment 18 | 9.3 | 89.6 | 3.66 | 9.3 | 90.5 | 3.56 | 1.02 | 3.69 | 1.33 | 4.58 |
| Embo diment 19 | 9.5 | 89.5 | 4.59 | 9.3 | 90.5 | 4.87 | 1.02 | 2.09 | 1.33 | 2.98 |
| Embo diment 20 | 9.1 | 89.7 | 3.52 | 9.4 | 90.4 | 3.55 | 0.82 | 2.96 | 1.15 | 3.71 |
| Embo diment 21 | 9.1 | 88.8 | 3.91 | 9.2 | 89.0 | 3.94 | 0.98 | 3.00 | 1.13 | 3.78 |
| Embo diment 22 | 9.2 | 90.5 | 3.31 | 9.4 | 91.1 | 3.36 | 1.38 | 3.55 | 1.53 | 4.25 |
| Embo diment 23 | 5.8 | 85.9 | 3.88 | / | / | / | 1.12 | / | 1.35 | / |
| Embo diment 24 | / | / | / | 6.2 | 85.6 | 12.8 | / | 4.96 | / | 5 |
| Embo diment 25 | 9.1 | 89.6 | 3.52 | 9.3 | 90.4 | 3.58 | 1.03 | 3.17 | 1.35 | 3.97 |
| Comp arative embod iment 1 | 27.5 | 90.2 | 3.33 | 27.8 | 90.6 | 3.54 | 3.1 | 3.16 | 3.88 | 3.98 |
| Comp arative embod iment 2 | 5.5 | 84.1 | 3.58 | 5.8 | 85.1 | 3.56 | 1.01 | 3.02 | 1.13 | 3.98 |
| Comp arative embod iment 3 | 20.5 | 89.8 | 0.56 | 20.6 | 90.0 | 0.57 | 1.01 | 1.43 | 1.13 | 1.89 |
| Comp arative embod iment 4 | 7.3 | 87.4 | 24.3 | 7.4 | 88.5 | 24.6 | 1.15 | 4.98 | 1.25 | 5.13 |
| Comp arative embod iment 5 | 10.2 | 86.8 | 4.51 | 10.3 | 86.7 | 4.89 | 6.02 | 7.15 | 6.33 | 7.98 |

**Table 2**

| | Aging and degradation of the modules | |
|---|---|---|
| | A (%) | B (%) |
| Embodiment 1 | / | 2.12 |
| Embodiment 2 | / | 2.60 |
| Embodiment 3 | / | 1.75 |
| Embodiment 4 | / | 1.77 |
| Embodiment 5 | / | 2.11 |
| Embodiment 6 | / | 2.05 |
| Embodiment 7 | 2.50 | / |
| Embodiment 8 | 3.20 | / |
| Embodiment 9 | 2.10 | / |
| Embodiment 10 | 2.80 | / |
| Embodiment 11 | 2.65 | / |
| Embodiment 12 | 3.80 | 3.88 |
| Embodiment 13 | 1.29 | 1.36 |
| Embodiment 14 | 2.09 | 2.11 |
| Embodiment 15 | 2.11 | 2.12 |
| Embodiment 16 | 2.09 | 2.13 |
| Embodiment 17 | 2.15 | 2.16 |
| Embodiment 18 | 2.13 | 2.15 |
| Embodiment 19 | 2.05 | 2.09 |
| Embodiment 20 | 2.04 | 2.06 |
| Embodiment 21 | 2.01 | 2.03 |
| Embodiment 22 | 2.21 | 2.23 |
| Embodiment 23 | / | 1.65 |
| Embodiment 24 | 1.71 | / |
| Embodiment 25 | 2.05 | 2.09 |
| Comparative embodiment 1 | 4.58 | 4.62 |
| Comparative embodiment 2 | 1.52 | 1.53 |
| Comparative embodiment 3 | 3.92 | 3.95 |
| Comparative embodiment 4 | 1.82 | 1.85 |
| Comparative embodiment 5 | 2.25 | 2.29 |

It could be seen from the data of the embodiments and comparative embodiments of the present disclosure, according to the light transmittance test standard of GBIT 2410-2008, the light transmittance of the encapsulation adhesive film in the above embodiments in the ultraviolet light wavebands of wavelength 280-380 nm were not more than 20%, and the light transmittance of the encapsulation adhesive film in the visible light wavebands of wavelength 400-1100 nm were not less than 85%. However, the light transmittance in the ultraviolet light wavebands of wavelength 280-380 nm of Comparative embodiment 1 (which the content of the ultraviolet light absorption agent in the ultraviolet light absorption layer was less than 0.1 g/m³) and Comparative embodiment 3 (which the content of the ultraviolet light conversion agent in the ultraviolet light conversion layer was less than 0.1 g/m³) were more than 20%, as measured by Method 1 and Method 2. The light transmittance in the visible light wavebands of wavelength 400-1100 nm of Comparative embodiment 2 (which the content of the ultraviolet light absorption agent in the ultraviolet light absorption layer was more than 10 g/m³) were less than 85%, as measured by Method 2. The haze in the visible light wavebands of wavelength 400-700 nm of Comparative embodiment 4 (which the content of the ultraviolet light conversion agent in the ultraviolet light conversion layer was more than 10 g/m³) was more than 24%, as measured by Method 1 and Method 2. The yellowing index of Comparative embodiment 5 (which the same layer containing both the ultraviolet light absorption agent and the ultraviolet light conversion agent) was obviously higher than all the Embodiments.

The description above of the Embodiments is only used to help understand the technical method and core ideas of the present disclosure. It should be noted that, for those ordinary skilled in the art, the variations and modifications can be performed to the present disclosure without departing from the principles, and all the variations and modifications also fall into the protection scope of the claims of the present disclosure.

## Claims

1. An encapsulation adhesive film comprises at least two layers, wherein the encapsulation adhesive film comprises an ultraviolet light absorption layer and an ultraviolet light conversion layer; the ultraviolet light absorption layer comprises a matrix resin and an ultraviolet light absorption agent; the ultraviolet light conversion layer comprises the matrix resin and an ultraviolet light conversion agent; the content of the ultraviolet light absorption agent in the ultraviolet light absorption layer is 0.1 g/m²-10 g/m²; the content of the ultraviolet light conversion agent in the ultraviolet light conversion layer is 0.1 g/m²-10 g/m².

2. The encapsulation adhesive film according to claim 1, wherein the content of the ultraviolet light absorption agent in the ultraviolet light absorption layer is 5 g/m²-10 g/m²; the content of the ultraviolet light conversion agent in the ultraviolet light conversion layer is 0.1 g/m²-2 g/m².

3. The encapsulation adhesive film according to claim 1, wherein the content of the ultraviolet light conversion agent in the ultraviolet light conversion layer is 5 g/m²-10 g/m²; the content of the ultraviolet light absorption agent in the ultraviolet light absorption layer is 0.1 g/m²-2 g/m².

4. The encapsulation adhesive film according to claim 1, wherein the ultraviolet light absorption agent comprises at least one of ethyl 2-cyano-3,3-diphenylpropenoate, p-methoxycinnamic acid ethylhexyl, isooctyl p-methoxycinnamate, dimethyl 4-methoxybenzylidene malonate, N-(2-ethoxyphenyl)-N'-(4-ethylphenyl)-oxalamide, 2-(2'-hydroxy-5'-tert-octylphenyl) benzotriazole, 2-(2'-hydroxy-3'-tert-butyl-5'-methylphenyl)-5-chlorobenzotriazole, 2-(4,6-, 3,5-di-tert-butyl-4-hydroxybenzoic acid) n-hexadecyl ester, 2-(4,6-diphenyl-1,3,5-triazine-2)-5-n-hexyloxyphenol, 2-(2'-hydroxy-5'-methylphenyl) benzotriazole or polysiloxane.

5. The encapsulation adhesive film according to claim 1, wherein the ultraviolet light conversion agent is selected from one or more of organic fluorescent pigments, Eu³⁺ doped rare earth oxides and quantum dots; the organic fluorescent pigments are selected from mixed rare earth coordination compounds of β-diketones and pyridine derivatives; the Eu³⁺ doped rare earth oxides are selected from one or more of Y₂Mo₆-Eu³⁺, Y₂O₂S-Eu³⁺, Gd₂O₃-Eu³⁺/Bi³⁺ and YVO₄-Eu³⁺; and the quantum dots are selected from one or more of Si quantum dots, GaAs quantum dots, CdS quantum dots, CdSe quantum dots, CdTe quantum dots, ZnS quantum dots, ZnSe quantum dots or ZnTe quantum dots.

6. The encapsulation adhesive film according to claim 1, wherein referring to the light transmittance test standard of GBIT 2410-2008, the light transmittance of the encapsulation adhesive film in the ultraviolet light wavebands of wavelength 280-380 nm is not more than 20%; the light transmittance of the encapsulation adhesive film in the visible light wavebands of wavelength 400-1100 nm is not less than 85%.

7. An electronic device, comprising an encapsulation adhesive film, wherein the encapsulation adhesive film being the encapsulation adhesive film as claimed in any one of claims 1-6; the electronic device is selected from any one of photovoltaic modules, an electroluminescent device, and a plasma display device.

8. The electronic device according to claim 7, wherein the photovoltaic modules being HJT cells modules.

9. The electronic device according to claim 7, the photovoltaic modules comprises a glass layer, a first encapsulation adhesive film layer, a cell array, a second encapsulation adhesive film layer and a cover plate, wherein the first encapsulation adhesive film layer being the encapsulation adhesive film; the ultraviolet light absorption layer is provided on the cell array side of the photovoltaic modules, and the ultraviolet light conversion layer is provided on the glass layer side of the photovoltaic modules; the content of the ultraviolet light conversion agent in the ultraviolet light conversion layer is 5 g/m²-10 g/m²; the content of the ultraviolet light absorption agent in the ultraviolet light absorption layer is 0.1 g/m²-2 g/m².

10. The electronic device according to claim 7, the photovoltaic modules comprises a glass layer, a first encapsulation adhesive film layer, a cell array, a second encapsulation adhesive film layer and a cover plate, wherein the second encapsulation adhesive film layer being the encapsulation adhesive film; the ultraviolet light conversion layer is provided on the cell array side of the photovoltaic modules, and the ultraviolet light absorption layer is provided on the cover plate side of the photovoltaic modules; the content of the ultraviolet light absorption agent in the ultraviolet light absorption layer is 5 g/m²-10 g/m²; the content of the ultraviolet light conversion agent in the ultraviolet light conversion layer is 0.1 g/m²-2 g/m².

11. A laminated glass, comprising at least two glass layers and an encapsulation adhesive film provided between adjacent the two glass layers, wherein the encapsulation adhesive film being the encapsulation adhesive film as claimed in any one of claims 1-6.
